# EUROPEAN PATENT APPLICATION

(11) **EP 4 385 800 A1**
(43) Date of publication of application: **19.06.2024**
(21) Application number: 22213478.5
(22) Date of filing: 14.12.2022
(51) Int. Cl.: B60L 50/64, B60L 50/60, B60L 58/18, H02J 7/00, H01M 10/42, H01M 10/44

(54) **METHOD FOR OPERATING A BATTERY SYSTEM, DATA PROCESSING APPARATUS, COMPUTER PROGRAM, COMPUTER-READABLE STORAGE MEDIUM, BATTERY SYSTEM, DRIVETRAIN AND VEHICLE**

(71) Applicant: Volvo Car Corporation, 405 31 Göteborg (SE)
(72) Inventor: FORSSELL, Jonas, 40531 Göteborg (SE); EKSTRÖM, Markus, 40531 Göteborg (SE); SINGH, Aditya Pratap, 40531 Göteborg (SE); REXED, Ivan, 40531 Göteborg (SE)
(74) Representative: Maiwald GmbH

(57) **Abstract**

The disclosure relates to a method for operating a battery system (16) comprising a plurality of battery cells (C1 to CN) and a plurality of cell-level inverter units (I1 to IN), wherein each of the cell-level inverter units (I1 to IN) is electrically coupled to a single battery cell (C1 to CN) out of the plurality of battery cells (C1 to CN) or to a group of battery cells out of the plurality of battery cells (C1 to CN). The method comprises requesting a first cell-level inverter unit (I1) to enable a first discharge current. Additionally, a second cell-level inverter unit (12) is requested to disable a second discharge current. Subsequently, the second cell-level inverter unit (I2) is requested to enable the second discharge current and the first cell-level inverter unit (I1) is requested to disable the first discharge current. Moreover, a corresponding data processing apparatus (20), a computer program (28), and a computer-readable storage medium (26) are described. Furthermore, a battery system (16), a drivetrain (12) for a vehicle and a vehicle (10) are presented.

## Description

The present disclosure relates to a method for operating a battery system comprising a plurality of battery cells and a plurality of cell-level inverter units, each of the cell-level inverter units being electrically coupled to a single battery cell out of the plurality of battery cells or to a group of battery cells out of the plurality of battery cells.

The present disclosure is additionally directed to a corresponding data processing apparatus, a corresponding computer program, and a corresponding computer-readable storage medium.

Moreover, the present disclosure relates to a battery system comprising a plurality of battery cells and a plurality of cell-level inverter units, wherein each of the cell-level inverter units is electrically coupled to a single battery cell out of the plurality of battery cells or to a group of battery cells out of the plurality of battery cells.

Furthermore, the present disclosure is directed to a drivetrain for an electric vehicle and a vehicle.

Vehicles using one or more electric traction motors are generally known. Such vehicles, be it battery electric vehicles or hybrid electric vehicles, usually comprise a battery system for storing energy being necessary to power the one or more traction motors. Such a battery system may also be called a traction battery system.

It is also known that starting a vehicle having such a battery system in cold environments is challenging. This is mainly due to the sluggish reaction of kinetics the battery system at low temperatures.

In order to be able to provide sufficient motor torque and motor power when starting the vehicle, comparatively high currents need to be extracted from the battery system. In a cold environment, this may compromise the battery life, i.e. reduce the service life of the battery.

In order to solve this problem, heating devices have been proposed such that traction battery systems may be heated before actually being started, i.e. before being used for powering a traction motor. However, providing a heating device increases the structural complexity of the battery system.

It is, thus, an objective of the present disclosure to provide a battery system which at the same time is structurally simple and may be started in a comparatively cold environment without causing an excessive reduction of battery life.

The problem is at least partially solved or alleviated by the subject matter of the independent claims of the present disclosure, wherein further examples are incorporated in the dependent claims.

According to a first aspect, there is provided a method for operating a battery system. The battery system comprises a plurality of battery cells and a plurality of cell-level inverter units. Each of the cell-level inverter units is electrically coupled to a single battery cell out of the plurality of battery cells or to a group of battery cells out of the plurality of battery cells. The method comprises:
- requesting a first cell-level inverter unit to enable a first discharge current and requesting a second cell-level inverter unit to disable a second discharge current, and
- requesting the second cell-level inverter unit to enable the second discharge current and requesting the first cell-level inverter unit to disable the first discharge current.

It is understood that the first cell-level inverter unit is electrically coupled to a first single battery cell or a first group of battery cells. In the same manner, the second cell-level inverter unit is electrically coupled to a second single battery cell or a second group of battery cells. Thus, the first discharge current, if enabled, originates from the first single battery cell or the first group of battery cells. The second discharge current, if enabled, originates from the second single battery cell or the second group of battery cells. This means that in a first step, the first single battery cell or the first group of battery cells is enabled to be used to provide a current which may be used for powering an electric traction machine. In a second step, the second single battery cell or the second group of battery cells is enabled to be used to provide a current which may be used for powering an electric traction machine. It is noted that the first single battery and the second single battery are overlap-free. This means that one specific battery cell of the battery system is either the first single battery cell or the second single battery cell. The same applies to the first group of battery cells and the second group of battery cells. Each specific battery cell of the battery system either forms part of the first group of battery cells or the second group of battery cells. Thus, while the first single battery cell or the first group of battery cells is used to provide a current, the second single battery cell or the second group of battery cells is not used for providing a current. In a case in which the second single battery cell or the second group of battery cells is used to provide a current, the first single battery cell or the first group of battery cells is not used. Consequently, each of the batteries cells only has to provide a current for a comparatively short time span. The battery cells not being used to provide a current are able to recover from the thermal and electrical stress that the withdrawal of current imposes. After the recovery, the battery cells are again able to provide a stable voltage. When applying this method in a comparatively cold environment, the negative influences of the cold environment on the starting of the battery system are mitigated and, as a consequence, the battery life is enhanced. This is especially the case when comparing the method of the present disclosure to known methods according to which a current is withdrawn from all battery cells at the same time. Additionally, also as compared to known battery systems, since only a portion of battery cells is used at each point in time, comparatively high currents have to be provided by these battery cells. This leads to an effective and efficient heating of the battery system.

A comparatively cold environment may be understood as an environment having an ambient temperature of -20°C or lower or temperatures of -25°C or lower. Analogously, comparatively low temperatures may be understood as temperatures of -20°C or lower or temperatures of -25°C or lower.

In an example, requesting the first cell-level inverter unit to enable the first discharge current and requesting the second cell-level inverter unit to enable the second discharge current is performed in accordance with a predefined pattern. In a case in which the predefined pattern is used when starting the battery system in a comparatively cold environment, the predefined pattern may also be called a cold start protocol. The predefined pattern may be characterized by at least one of a duration during which the first cell level inverter unit is requested to enable the first discharge current, a duration during which the second cell level inverter unit is requested to enable the second discharge current, a time span between requesting the first cell level inverter unit to enable the first discharge current and requesting the second cell level inverter unit to enable the second discharge current, and an order according to which the first cell-level inverter unit and the second cell-level inverter unit are requested to enable the corresponding discharge current. The pattern may also be a function of an environmental parameter e.g. temperature.

In an example, the first discharge current is enabled for a predefined time. Additionally or alternatively, the second discharge current is enabled for a predefined time. This means that the corresponding battery cells are only providing the first discharge current or the second discharge current for a predefined time which may be relatively short, e.g. a few milliseconds to a few seconds. Thereafter, other battery cells are used. This has the effect, that even in a relatively cold environment, a current of sufficient magnitude may be provided without compromising the battery life.

In an example, the first discharge current is enabled until a first operational voltage of the first, single battery cell or the first group of battery cells falls below a predefined first cut-off voltage. Additionally or alternatively, the second discharge current is enabled until a second operational voltage of the second, single battery cell or the second group of battery cells falls below a predefined second cut-off voltage. In this context, the operational voltage of the first, single battery cell or the first group of battery cells or the second single battery cell or the second group of battery cells may be taken as an indicator of the stress to which the respective battery cell group of battery cells is subject. The first cut-off voltage and/or the second cut-off voltage is chosen such that this stress does not exceed a predefined level. In other words, the respective battery cells are not used for providing a currents, if the risk of compromising the battery life is too high. Overall, such a battery system may be started in a comparatively cold environment without compromising the battery life.

In an example, the first discharge current is enabled until a first electric charge quantity is withdrawn from the first, single battery cell or the first group of battery cells. Additionally or alternatively, the second discharge current is enabled until a second electric charge quantity is withdrawn from the second, single battery cell or the second group of battery cells. Thus, a fixed charge quantity is withdrawn from each battery cell before it is disabled and different battery cells are used for providing current. In a cold environment, stress on a specific battery cell increases with the charge quantity being withdrawn therefrom. Thus, by limiting the charge quantity to be withdrawn, also the stress on the respective battery cells is reduced. When applying this in a comparatively cold environment, negative effects on the battery life are eliminated or at least mitigated. In other words, battery life is enhanced.

In the above examples, stress to which a battery cell is subject may be thermal stress and/or electrical stress.

In an example, the first, single battery cell or the first group of battery cells and the second, single battery cell or the second group of battery cells are arranged adjacent to one another. In other words, the battery cells are arranged in a row or stacked. This has the effect that heat being generated by one battery cell due to the withdrawal of a current, may be used in order to warm up neighboring battery cells. In such a configuration, a separate heating device is not necessary. Consequently, the corresponding battery system is structurally simple.

In an example, the method further comprises:
- receiving or determining an environmental temperature and
- performing the method if the environmental temperature is inferior to an environmental temperature threshold or, otherwise, abandoning the method.

This means that the present method may only be performed in a case in which the battery system is located in a comparatively cold environment. As has already been mentioned before, the temperature threshold may be -20°C. In another example, the temperature threshold may be -25°C. Put otherwise, the method according to the present disclosure is only used, if this is necessary due to an environmental temperature.

In an example, the method further comprises:
- receiving or determining a battery system temperature and
- performing the method if the battery system temperature is inferior to a battery system temperature threshold or, otherwise, abandoning the method.

This means that the present method may only be performed in a case in which the battery system is comparatively cold. As has already been mentioned before, the temperature threshold may be -20°C. In another example, the temperature threshold may be -25°C. Put otherwise, the method according to the present disclosure is only used, if this is necessary due to a temperature of the battery system.

It is noted that the method according to the present disclosure may as well be performed as function of both the environmental temperature and the battery system temperature.

In an example, the method further comprises subsequently requesting a third cell-level inverter unit being electrically coupled to a third single battery cell or a third group of battery cells, to enable a third discharge current originating from the third single battery cell or the third group of battery cells. Additionally, the first cell-level inverter unit is requested to disable the first discharge current and the second cell-level inverter unit is requested to disable the second discharge current. Thus, the method may also be applied to a battery system having three single battery cells or three groups of battery cells. In this context, at any given point in time, only one of the single battery cells or only one of the groups of battery cells is used in order to provide a discharge current. The remaining single battery cells or the remaining groups of battery cells are not used. Also in this example, the battery system may be started in a comparatively cold environment. At the same time, negative influences on the battery life are reduced or eliminated.

It is understood, that the method according to the present disclosure may as well be used for battery systems having four or more single battery cells or four or more groups of battery cells. For example, the battery system may comprise 4 to 200 single battery cells. In another example, the battery system may comprise 5 to 20 groups of battery cells. The effects and advantages are the same as has already been explained above.

It is noted that the term discharge current as used in the present disclosure may relate to an AC signal. Moreover, the term discharge current may relate to a group of AC signals differing for example in their respective phase. In an example, the term discharge current relates to a group of three AC signals differing in their respective phase and being configured for powering an electric traction machine.

In a case in which there are three or more single battery cells or groups of battery cells, the discharge current may be provided by one of the single battery cells or the group of the various cells in a predefined order. If at the same time, the battery cells are arranged in a row, the order of using the battery cells may correspond to a line-up direction of the row.

The method may be at least partly computer-implemented, and may be implemented in software or in hardware, or in software and hardware. Further, the method may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a second aspect, there is provided a data processing apparatus comprising means for carrying out the method of the present disclosure. Thus, when using such a data processing apparatus in a situation of a comparatively cold environment, the negative influences of the cold environment on the starting of the battery system are mitigated and, as a consequence, the battery life is enhanced.

According to a third aspect, there is provided a computer program comprising instructions which, when the computer program is executed by a computer, cause the computer to carry out the method of the present disclosure. Using such a computer program in a situation of a comparatively cold environment has the effect that the negative influences of the cold environment on the starting of the battery system are mitigated and, as a consequence, the battery life is enhanced.

According to a fourth aspect, there is provided a computer-readable storage medium comprising instructions which, when executed by a computer, cause the computer to carry out the method of the present disclosure. Such a computer-readable storage leads to a reduction of negative influences of a cold environment on the starting of the battery system, if applied in a relatively cold environment. Consequently, the battery life is enhanced.

According to a fifth aspect, there is provided a battery system comprising a plurality of battery cells and a plurality of cell-level inverter units. Each of the cell-level inverter units is electrically coupled to a single battery cell out of the plurality of battery cells or to a group of battery cells out of the plurality of battery cells. The battery system also comprises a data processing apparatus according to the present disclosure. The data processing apparatus is communicatively coupled to each of the cell-level inverter units. Such a battery system is particularly well-suited for being used in a comparatively cold environment. In more detail, when starting such a battery system in a comparatively cold environment, negative influences on the service life of the battery system are comparatively small. This is especially the case when comparing the battery system according to the present disclosure to a known battery systems.

According to a sixth aspect, there is provided a drivetrain for an electric vehicle. The drivetrain comprises a battery system according to the present disclosure and an electric traction motor being electrically coupled to the battery system. Due to the effects that have already been explained above, such a drivetrain has a comparatively long service life.

According to a seventh aspect, there is provided a vehicle comprising a drivetrain of the present disclosure. Since the drivetrain has a comparatively long service life, also the vehicle can enjoy a relatively long service life.

It should be noted that the above examples may be combined with each other irrespective of the aspect involved.

These and other aspects of the present disclosure will become apparent from and elucidated with reference to the examples described hereinafter.

Examples of the disclosure will be described in the following with reference to the following drawings.
- Figure 1: shows a vehicle according to the present disclosure having a drivetrain according to the present disclosure with a battery system according to the present disclosure, wherein the battery system may be operated using a method according to the present disclosure,
- Figure 2: shows a more detailed view of the battery system of Figure 1 along direction II of Figure 1,
- Figure 3: shows an evolution of an output voltage of a known battery cell over time at room temperature and at a temperature of -20°C, and
- Figure 4: illustrates the method according to the present disclosure by an evolution of output voltages of a plurality of battery cells.

The Figures are merely schematic representations and serve only to illustrate examples of the disclosure. Identical or equivalent elements are in principle provided with the same reference signs.

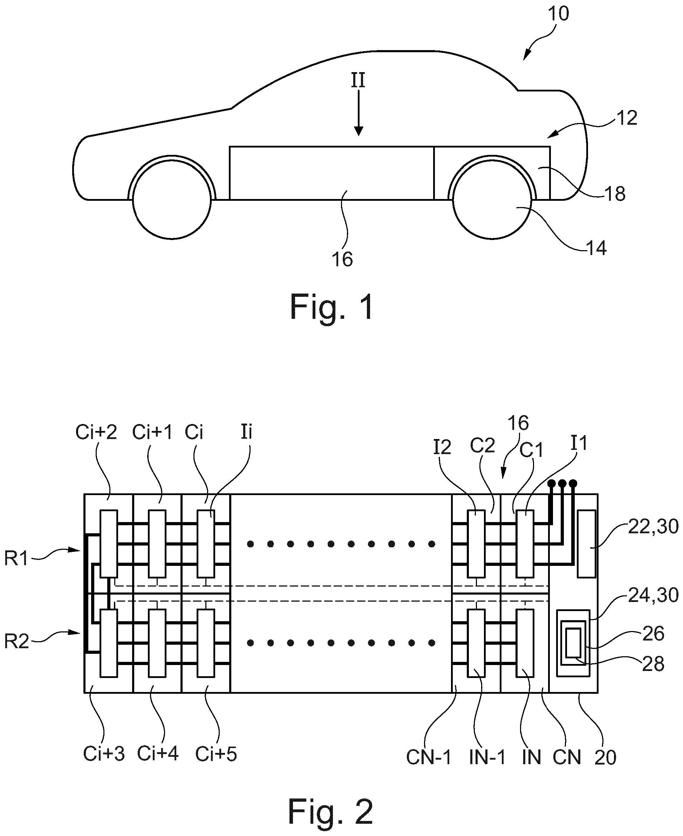

Figure 1 shows a vehicle 10 being a battery electric vehicle.

The vehicle 10 comprises a drivetrain 12 which is configured for propelling the rear wheels 14 of the vehicle 10.

The drivetrain comprises a battery system 16 and an electric traction motor 18 being electrically coupled to the battery system 16.

The battery system 16 is shown in more detail in Figure 2.

The battery system 16 comprising a plurality of battery cells being denoted C1 to CN. For the ease of representation, only some of the battery cells C1 to CN are represented in Figure 2. In a more general way, the battery cells may be denoted Ci, wherein i is a counting index.

In the present example, the battery cells C1 to CN are arranged in two parallel rows R1, R2. It is understood that this is just an example and the battery cells C1 to CN can as well be arranged in a single row or in three or more rows.

Each of the battery cells C1 to CN is equipped with a cell-level inverter unit being denoted I1 to IN. this means that each cell-level inverter unit I1 to IN is electrically connected to the poles of the associated battery cell C1 to CN.

Each of the cell-level inverter units I1 to IN is configured to convert a direct current signal being provided by the associated battery cell C1 to CN into an alternating current signal or even a group of alternating current signals. In the present example, each of the cell-level inverter units I1 to IN is configured to provide three alternating current signals of different phases.

These alternating current signals may be directly used in order to power the traction motor 18.

The battery system 16 additionally comprises a data processing apparatus 20.

Generally speaking, the data processing apparatus 20 is configured to control the cell-level inverter units I1 to IN, i.e. the data processing apparatus 20 is configured to control the drivetrain 12.

To this end, the data processing apparatus 20 is communicatively coupled to each of the cell-level inverter units I1 to IN. Corresponding communication lines are illustrated by dashed lines in Figure 2.

The data processing apparatus 20 comprises a data processing unit 22 and a data storage unit 24.

The data storage unit 24 comprises a computer-readable storage medium 26.

On the computer-readable storage medium 26, there is provided a computer program 28 comprising instructions which, when the computer program is executed by the data processing unit 22 or, more generally, a computer, cause the computer or the data processing unit 22 to carry out the method for operating a battery system.

Thus, also the computer-readable storage medium 26 comprises instructions which, when executed by the data processing unit 22 or a computer, cause the data processing unit 22 or the computer to carry out the method for operating a battery system.

Consequently, the data processing unit 22 and the data storage unit 24 form means 30 for carrying out the method for operating a battery system.

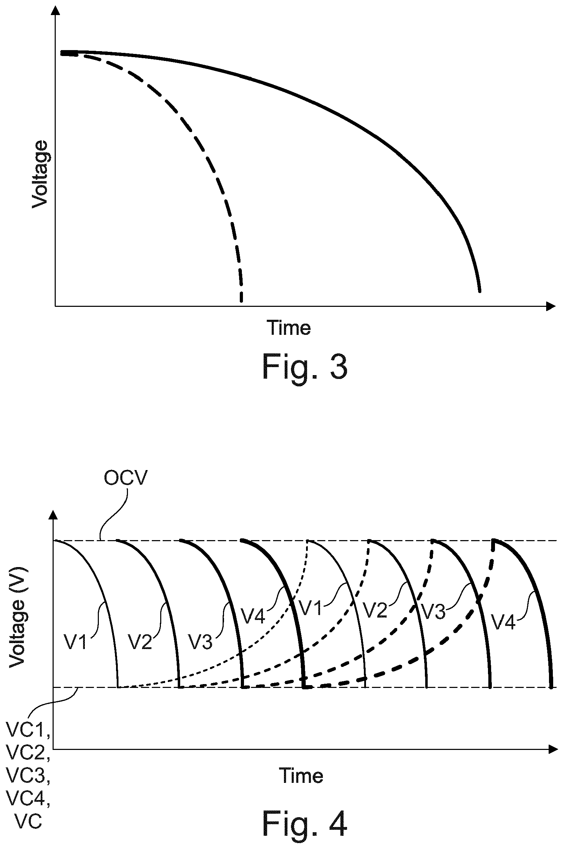

Before explaining the method for operating a battery system in more detail, reference is made to Figure 3.

Figure 3 shows an evolution of a voltage of a general known battery cell over time, while a current is withdrawn from the battery cell. In other words, Figure 3 shows the evolution of a voltage of the battery cell while the battery cell is used.

The diagram of Figure 3 comprises two curves. The first curve being represented in a solid line represents the evolution of the voltage, if the battery cell is discharged at room temperature.

The second curve being represented in dashed line represents the evolution of the voltage, if the battery cell is discharged at -20°C.

It is, thus, easily visible from the diagram of Figure 3 that in a cold environment, the voltage of a battery cell drops significantly faster and earlier than at room temperature. Since in standard use cases of a battery cell, a minimum voltage is required, e.g. for powering an electric motor, only a significantly reduced capacity of the battery cell can be used in a cold environment.

The behavior as illustrated in Figure 3 may describe the behavior of each of the battery cells C1 to CN of the battery system 16.

In the following, the method for operating the battery system will be explained in connection with Figure 4.

This method makes use of the fact that each of the battery cells C1 to CN is equipped with a cell-level inverter unit I1 to IN.

For the purpose of illustration, the method will be illustrated for a battery system 16 comprising four battery cells C1 to C4 only. It is understood that in reality, the battery system 16 can comprise up to 150 or 200 battery cells.

As has been mentioned before, the method for operating the battery system 16 is especially suitable for operating the battery system 16 in a cold environment. More precisely, the method for operating the battery system, is directed to a cold start situation for a battery system 16. This means that the battery system 16 is started to be used in a cold environment, e.g. at an environmental temperature of -20°.

Consequently, in a first step of the method, an environmental temperature is received or determined.

If the environmental temperature is found to equal or exceed the predefined environmental temperature threshold, in the present example -20°C, the method is abandoned.

Only if the environmental temperature is found to be lower than -20°C, the method is continued.

It is noted that in an alternative, instead of the environmental temperature, a battery system temperature is used. Thus, the method is abandoned, if the battery system temperature is found to equal or exceed a battery system temperature threshold.

Only if the battery system temperature is lower than the battery system temperature threshold, the method is continued.

In case the method is continued, the next step is performed.

In this step, the first cell-level inverter unit I1 being electrically coupled to the first single battery cell C1 is requested to enable a first discharge current originating from the first single battery cell C1.

At the same time, the second cell-level inverter unit I2 being electrically coupled to the second single battery cell C2 is requested to disable a second discharge current originating from the second single battery cell C2.

Moreover, the third cell-level inverter unit I3 being electrically coupled to the third single battery cell C3 is requested to disable a third discharge current originating from the third single battery cell C3.

Additionally, the fourth cell-level inverter unit I4 being electrically coupled to the fourth single battery cell C4 is requested to disable a fourth discharge current originating from the fourth single battery cell C4.

Consequently, at this stage of the method, only the first battery cell C1 delivers a discharge current which is used for powering the electric traction motor 18.

It is understood, that the first discharge current is of sufficient magnitude to perform this task. It is also understood that compared to known methods for operating a battery system, wherein all battery cells deliver a current at the same time, the first discharge current is of relatively high magnitude.

Thereafter, in a next step, the first cell-level inverter unit I1 being electrically coupled to the first single battery cell C1 is requested to disable the first discharge current originating from the first single battery cell C1.

At the same time, the second cell-level inverter unit I2 being electrically coupled to the second single battery cell C2 is requested to enable a second discharge current originating from the second single battery cell C2.

As before, the third cell-level inverter unit I3 being electrically coupled to the third single battery cell C3 is requested to disable a third discharge current originating from the third single battery cell C3 and the fourth cell-level inverter unit I4 being electrically coupled to the fourth single battery cell C4 is requested to disable a fourth discharge current originating from the fourth single battery cell C4.

Consequently, at this stage of the method, only the second battery cell C2 delivers a discharge current which is used for powering the electric traction motor 18.

It is again understood, that the second discharge current is of sufficient magnitude to perform this task. It is also understood that compared to a known methods for operating a battery system, wherein all battery cells deliver a current at the same time, the second discharge current is of relatively high magnitude.

Thereafter, in a following step, the first cell-level inverter unit I1 being electrically coupled to the first single battery cell C1 is requested to disable the first discharge current originating from the first single battery cell C1.

At the same time, the second cell-level inverter unit I2 being electrically coupled to the second single battery cell C2 is requested to disable a second discharge current originating from the second single battery cell C2.

However, now the third cell-level inverter unit I3 being electrically coupled to the third single battery cell C3 is requested to enable a third discharge current originating from the third single battery cell C3.

The fourth cell-level inverter unit I4 being electrically coupled to the fourth single battery cell C4 is still requested to disable a fourth discharge current originating from the fourth single battery cell C4.

Consequently, at this stage of the method, only the third battery cell C3 delivers a discharge current which is used for powering the electric traction motor 18.

It is again understood, that the third discharge current is of sufficient magnitude to perform this task. It is also understood that compared to a known methods for operating a battery system, wherein all battery cells deliver a current at the same time, the third discharge current is of relatively high magnitude.

Subsequently, in a next step, the first cell-level inverter unit I1 being electrically coupled to the first single battery cell C1 is requested to disable the first discharge current originating from the first single battery cell C1.

At the same time, the second cell-level inverter unit I2 being electrically coupled to the second single battery cell C2 is requested to disable a second discharge current originating from the second single battery cell C2.

The third cell-level inverter unit I3 being electrically coupled to the third single battery cell C3 is requested to disable a third discharge current originating from the third single battery cell C3.

However, the fourth cell-level inverter unit I4 being electrically coupled to the fourth single battery cell C4 is requested to enable a fourth discharge current originating from the fourth single battery cell C4.

Consequently, at this stage of the method, only the fourth battery cell C4 delivers a discharge current which is used for powering the electric traction motor 18.

It is again understood, that the fourth discharge current is of sufficient magnitude to perform this task. It is also understood that compared to a known methods for operating a battery system, wherein all battery cells deliver a current at the same time, the fourth discharge current is of relatively high magnitude.

In each of the steps as mentioned before, the discharge current of the respective battery cell C1, C2, C3, C4 is provided until a respective first operational voltage V1 of the first battery cell C1 falls below a first cut-off voltage VC1, a respective second operational voltage V2 of the second battery cell C2 falls below a second cut-off voltage VC2, a respective third operational voltage V3 of the third battery cell C3 falls below a third cut-off voltage VC3 or a respective fourth operational voltage V4 of the fourth battery cell C4 falls below a fourth cut-off voltage VC4.

The voltages V1, V2, V3, V4 are illustrated in Figure 4.

In the present example, all the cut-off voltages VC1, VC2, VC3, VC4 are the same and are denoted VC.

Moreover, Figure 4 illustrates an open circuit voltage OCV of each of the battery cells C1, C2, C3, C4. For the ease of explanation, it is assumed that the open circuit voltage OCV is the same for each of the battery cells C1, C2, C3, C4.

In summary, the battery cells C1, C2, C3, C4 are used in the order C1-C2-C3-C4.

In other words, the method for operating the battery system involves a predefined pattern of requesting the cell-level inverter unit I1, I2, 13, I4 to enable the corresponding first to fourth discharge current.

It is noted that Figure 4 shows two cycles of the above pattern, i.e. C1-C2-C3-C4-C1-C2-C3-C4.

In other examples, also other patterns are possible, for example C1-C3-C4-C2 or C1-C4-C2-C3 or C4-C3-C2-C1.

In the present example, the battery cells C1 to C4 are arranged in one row adjacent to one another. Since withdrawing a discharge current from each of the battery cells C1 to C4 generates heat, this heat also warms neighboring battery cells of the battery cell from which the discharge current is withdrawn.

It is noted that in an alternative, one, several ones or all of the first discharge current, the second discharge current, the third discharge current and the fourth discharge current may as well be enabled for a predefined time. This means that the cut-off voltages are replaced by corresponding cut-off times.

In a further alternative, one, several ones or all of the first discharge current, the second discharge current, the third discharge current and the fourth discharge current may as well be enabled until a first electric charge quantity, a second electric charge quantity, a third electric charge quantity or a fourth electric charge quantity. It is withdrawn from the corresponding first, second, third or fourth battery cell. This means that the cut-off voltages or the cut-off times are replaced by corresponding cut-off charge quantities.

In the above examples and variants of the method for operating a battery system and the battery system, single battery cells C1 to CN being equipped with a respective cell-level inverter units I1 to IN have been mentioned. It is understood that in an alternative it is also possible to provide one cell-level inverter unit for a group of battery cells respectively. The above explanations and effects also apply to this alternative.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: vehicle
- 12: drivetrain
- 14: rear wheels
- 16: battery system
- 18: electric traction motor
- 20: data processing apparatus
- 22: data processing unit
- 24: data storage unit
- 26: computer-readable storage medium
- 28: computer program
- 30: means for carrying out the method for operating a battery system

- C1 to CN: battery cell
- I1 to IN: cell-level inverter unit
- OCV: open circuit voltage
- R1: row of battery cells
- R2: row of battery cells
- V1: first operational voltage
- V2: second operational voltage
- V3: third operational voltage
- V4: fourth operational voltage
- VC1: first cut-off voltage
- VC2: second cut-off voltage
- VC3: third cut-off voltage
- VC4: fourth cut-off voltage
- VC: cut-off voltage

## Claims

1. A method for operating a battery system (16) comprising a plurality of battery cells (C1 to CN) and a plurality of cell-level inverter units (I1 to IN), each of the cell-level inverter units (I1 to IN) being electrically coupled to a single battery cell (C1 to CN) out of the plurality of battery cells (C1 to CN) or to a group of battery cells out of the plurality of battery cells (C1 to CN), comprising:
- requesting a first cell-level inverter unit (I1) to enable a first discharge current and requesting a second cell-level inverter unit (I2) to disable a second discharge current, and
- requesting the second cell-level inverter unit (I2) to enable the second discharge current and requesting the first cell-level inverter unit (I1) to disable the first discharge current.

2. The method of claim 1, wherein requesting the first cell-level inverter unit (I1) to enable the first discharge current and requesting the second cell-level inverter unit (I2) to enable the second discharge current is performed in accordance with a predefined pattern.

3. The method of any one of the preceding claims, wherein the first discharge current is enabled for a predefined time and/or wherein the second discharge current is enabled for a predefined time.

4. The method of any one of the preceding claims, wherein the first discharge current is enabled until a first operational voltage (V1) of the first, single battery cell (C1) or the first group of battery cells falls below a predefined first cut-off voltage (VC1), and/or wherein the second discharge current is enabled until a second operational voltage (V2) of the second, single battery cell (C2) or the second group of battery cells falls below a predefined second cut-off voltage (VC2).

5. The method of any one of the preceding claims, wherein the first discharge current is enabled until a first electric charge quantity is withdrawn from the first, single battery cell (C1) or the first group of battery cells and/or
wherein the second discharge current is enabled until a second electric charge quantity is withdrawn from the second, single battery cell (C2) or the second group of battery cells.

6. The method of any one of the preceding claims, wherein the first, single battery cell (C1) or the first group of battery cells and the second, single battery cell (C2) or the second group of battery cells are arranged adjacent to one another.

7. The method of any one of the preceding claims, further comprising:
- receiving or determining an environmental temperature and
- performing the method if the environmental temperature is inferior to an environmental temperature threshold or, otherwise, abandoning the method.

8. The method of any one of the preceding claims, further comprising:
- receiving or determining a battery system temperature and
- performing the method if the battery system temperature is inferior to a battery system temperature threshold or, otherwise, abandoning the method.

9. The method of any one of the preceding claims, further comprising: subsequently requesting a third cell-level inverter unit (13) being electrically coupled to a third single battery cell (C3) or a third group of battery cells, to enable a third discharge current originating from the third single battery cell (C3) or the third group of battery cells, requesting the first cell-level inverter unit (I1) to disable the first discharge current, and requesting the second cell-level inverter unit (I2) to disable the second discharge current.

10. A data processing apparatus (20) comprising means (30) for carrying out the method of any one of the preceding claims.

11. A computer program (28) comprising instructions which, when the computer program (28) is executed by a computer, cause the computer to carry out the method of claims 1 to 9.

12. A computer-readable storage medium (26) comprising instructions which, when executed by a computer, cause the computer to carry out the method of claims 1 to 9.

13. A battery system (16) comprising a plurality of battery cells (C1 to CN) and a plurality of cell-level inverter units (I1 to IN), wherein each of the cell-level inverter units (I1 to IN) is electrically coupled to a single battery cell (C1 to CN) out of the plurality of battery cells (C1 to CN) or to a group of battery cells out of the plurality of battery cells (C1 to CN), and a data processing apparatus (20) according to claim 10, wherein the data processing apparatus (20) is communicatively coupled to each of the cell-level inverter units (I1 to IN).

14. A drivetrain (12) for an electric vehicle (10), comprising a battery system (16) according to claim 13 and an electric traction motor (18) being electrically coupled to the battery system (16).

15. A vehicle (10) comprising a drivetrain (12) of claim 14.

## Amended claims

### Amended claims in accordance with Rule 137(2) EPC.

1. A method for operating a battery system (16) comprising a plurality of battery cells (C1 to CN) and a plurality of cell-level inverter units (I1 to IN), each of the cell-level inverter units (I1 to IN) being electrically coupled to a single battery cell (C1 to CN) out of the plurality of battery cells (C1 to CN) or to a group of battery cells out of the plurality of battery cells (C1 to CN), comprising:
- requesting a first cell-level inverter unit (I1) to enable a first discharge current for powering an electric traction machine (18) and requesting a second cell-level inverter unit (I2) to disable a second discharge current, and
- requesting the second cell-level inverter unit (I2) to enable the second discharge current for powering the electric traction machine (18) and requesting the first cell-level inverter unit (I1) to disable the first discharge current.

2. The method of claim 1, wherein requesting the first cell-level inverter unit (I1) to enable the first discharge current and requesting the second cell-level inverter unit (I2) to enable the second discharge current is performed in accordance with a predefined pattern.

3. The method of any one of the preceding claims, wherein the first discharge current is enabled for a predefined time and/or wherein the second discharge current is enabled for a predefined time.

4. The method of any one of the preceding claims, wherein the first discharge current is enabled until a first operational voltage (V1) of the first, single battery cell (C1) or the first group of battery cells falls below a predefined first cut-off voltage (VC1), and/or wherein the second discharge current is enabled until a second operational voltage (V2) of the second, single battery cell (C2) or the second group of battery cells falls below a predefined second cut-off voltage (VC2).

5. The method of any one of claims 1 to 3, wherein the first discharge current is enabled until a first electric charge quantity is withdrawn from the first, single battery cell (C1) or the first group of battery cells and/or
wherein the second discharge current is enabled until a second electric charge quantity is withdrawn from the second, single battery cell (C2) or the second group of battery cells.

6. The method of any one of the preceding claims, wherein the first, single battery cell (C1) or the first group of battery cells and the second, single battery cell (C2) or the second group of battery cells are arranged adjacent to one another.

7. The method of any one of the preceding claims, further comprising:
- receiving or determining an environmental temperature and
- performing the method if the environmental temperature is inferior to an environmental temperature threshold or, otherwise, abandoning the method.

8. The method of any one of the preceding claims, further comprising:
- receiving or determining a battery system temperature and
- performing the method if the battery system temperature is inferior to a battery system temperature threshold or, otherwise, abandoning the method.

9. The method of any one of the preceding claims, further comprising: subsequently requesting a third cell-level inverter unit (I3) being electrically coupled to a third single battery cell (C3) or a third group of battery cells, to enable a third discharge current originating from the third single battery cell (C3) or the third group of battery cells, requesting the first cell-level inverter unit (I1) to disable the first discharge current, and requesting the second cell-level inverter unit (I2) to disable the second discharge current.

10. A data processing apparatus (20) comprising means (30) for carrying out the method of any one of the preceding claims.

11. A computer program (28) comprising instructions which, when the computer program (28) is executed by a computer, cause the computer to carry out the method of claims 1 to 9.

12. A computer-readable storage medium (26) comprising instructions which, when executed by a computer, cause the computer to carry out the method of claims 1 to 9.

13. A battery system (16) comprising a plurality of battery cells (C1 to CN) and a plurality of cell-level inverter units (I1 to IN), wherein each of the cell-level inverter units (I1 to IN) is electrically coupled to a single battery cell (C1 to CN) out of the plurality of battery cells (C1 to CN) or to a group of battery cells out of the plurality of battery cells (C1 to CN), and a data processing apparatus (20) according to claim 10, wherein the data processing apparatus (20) is communicatively coupled to each of the cell-level inverter units (I1 to IN).

14. A drivetrain (12) for an electric vehicle (10), comprising a battery system (16) according to claim 13 and an electric traction motor (18) being electrically coupled to the battery system (16).

15. A vehicle (10) comprising a drivetrain (12) of claim 14.
